**Europäisches Patentamt**

**European Patent Office**

**Office européen des brevets**

(11) Veröffentlichungsnummer: **0 127 164**
A2

# (12) EUROPÄISCHE PATENTANMELDUNG

(21) Anmeldenummer: **84106008.0**

(22) Anmeldetag: **25.05.84**

(51) Int. Cl.³: **H 01 H 13/70**
**H 01 H 9/02**

(30) Priorität: **27.05.83 DE 3319334**

(43) Veröffentlichungstag der Anmeldung:
**05.12.84 Patentblatt 84/49**

(84) Benannte Vertragsstaaten:
**AT BE CH DE FR GB IT LI NL SE**

(71) Anmelder: **Siemens Aktiengesellschaft**
**Berlin und München Wittelsbacherplatz 2**
**D-8000 München 2(DE)**

(72) Erfinder: **Lemche, Josef**
**Koboldstrasse 36**
**D-8000 München 83(DE)**

(54) **Verriegelvorrichtung für ein zweiteiliges Tastaturgehäuse.**

(57) Die Erfindung bezieht sich auf eine Verriegelvorrichtung für ein zweiteiliges Tastaturgehäuse aus Kunststoff mit innenseitig angeordneter Schirmung. Eine befriedigende Schirmung wurde bei derartigen Kunststoffgehäusen bisher nur dadurch erreicht, daß in das Tastaturgehäuse verschraubte Blecheinsätze eingesetzt werden. Dies ist aber mit einem hohen Aufwand verbungen. Erfindungsgemäß wird der hohe Aufwand dadurch vermieden, daß das Tastaturunterteil 1 mindestens an einer Seite, vorzugsweise an der Vorderseite Durchbrüche 2 aufweist, in die am Tastaturoberteil 10 befestigte Haken 9 eingreifen. Unterhalb der Durchbrüche 2 ist eine Verschlußschiene 4 verschiebbar angeordnet, die im Abstand der Haken 9 mit schräg nach oben gebogenen Kontaktzungen 5 und mit Kontaktbuckeln 6 versehen ist. In der Mitte der Seiten der Tastaturunterteile 1, vorzugsweise an der Vorderseite, befindet sich ein Steg 7 und in der Verschlußschiene 4 eine Öffnung 8, die aufeinander so abgestimmt sind, daß die Verschlußschiene 4 mittels Werkzeug verschiebbar ist. Die Verriegelung nach der Erfindung ist vorzugsweise bei Tastaturgehäusender Datentechnik verwendbar.

FIG 2

Croydon Printing Company Ltd

EP 0 127 164 A2

SIEMENS AKTIENGESELLSCHAFT          Unser Zeichen
Berlin   und München                VPA  83 P 1 3 6 8 E

## Verriegelvorrichtung für ein zweiteiliges Tastaturgehäuse

Die Erfindung betrifft eine Verriegelvorrichtung für ein zweiteiliges Tastaturgehäuse aus Kunststoff mit innenseitig angeordneter Schirmung.

Tastaturgehäuse werden im allgemeinen in Blech- oder Metallspritztechnik mit lackierter Oberfläche ausgeführt. Diese Gehäuse weisen eine hohe Schirmgüte auf. Kunststoffgehäuse mit Metallbedampfung erfüllen die Forderung einer hohen Schirmgüte nur mit großem Aufwand und zwar im allgemeinen mit verschraubten Blecheinsätzen. Diese Lösungen sind aber äußerst aufwendig.

Aufgabe der vorliegenden Erfindung ist es daher, eine Verriegelvorrichtung    für Tastaturkunststoffgehäuse mit gleichzeitig guter Schirmwirkung zu schaffen.

Zur Lösung dieser Aufgabe wird die Verriegelvorrichtung derart ausgebildet, daß  das Tastaturgehäuseunterteil mindestens an einer Seite, vorzugsweise an der Vorderseite Durchbrüche aufweist, in die am Tastaturgehäuseoberteil befestigte Haken eingreifen, daß unterhalb der Durchbrüche in einem Führungskanal eine Verschlußschiene verschiebbar angeordnet ist, die im Abstand der Haken mit nach oben gebogenen Kontaktzungen und dazwischen mit Kontaktbuckeln versehen ist, und daß sich in der Mitte der Seiten des Tastenunterteils vorzugsweise an der Vorderseite ein Steg und in der Verschlußschiene eine Öffnung befinden, die aufeinander so abgestimmt sind, daß die Verschlußschiene mittels Werkzeug verschiebbar ist.

Zk 1 Fdl/ 10. 5. 1983

0127164

Die Verschlußschiene kann dabei aus Bandstahl bestehen.

Die Innenseiten des Tastaturober- und unterteils sind metallisiert oder, wenn höhere Schirmgüteforderungen bestehen, mit eingelegten Schirmblechen versehen.

Durch diese Maßnahmen erhält man ein zweiteiliges Tastaturgehäuse aus Kunststoff, das schraubenlos geöffnet und geschlossen werden kann. Da die Verriegelung gleichzeitig die Schirmkontaktierung übernimmt, ist auch eine den üblichen Blechgehäusen vergleichbare Schirmwirkung gegeben. Ein Kaltfließen des Kunststoffs wird dadurch ebenfalls vermieden.

Anhand der Ausführungsbeispiele nach den Figuren 1 bis 5 wird die Erfindung näher erläutert. Es zeigen:
Fig. 1 die Seitenansicht eines Tastaturgehäuses,
Fig. 2 einen Schnitt durch das Tastaturgehäuse,
Fig. 3 die Verschlußschiene,
Fig. 4 einen Schnitt durch die Verschlußschiene,
Fig. 5 einen Ausschnitt aus Fig. 1.

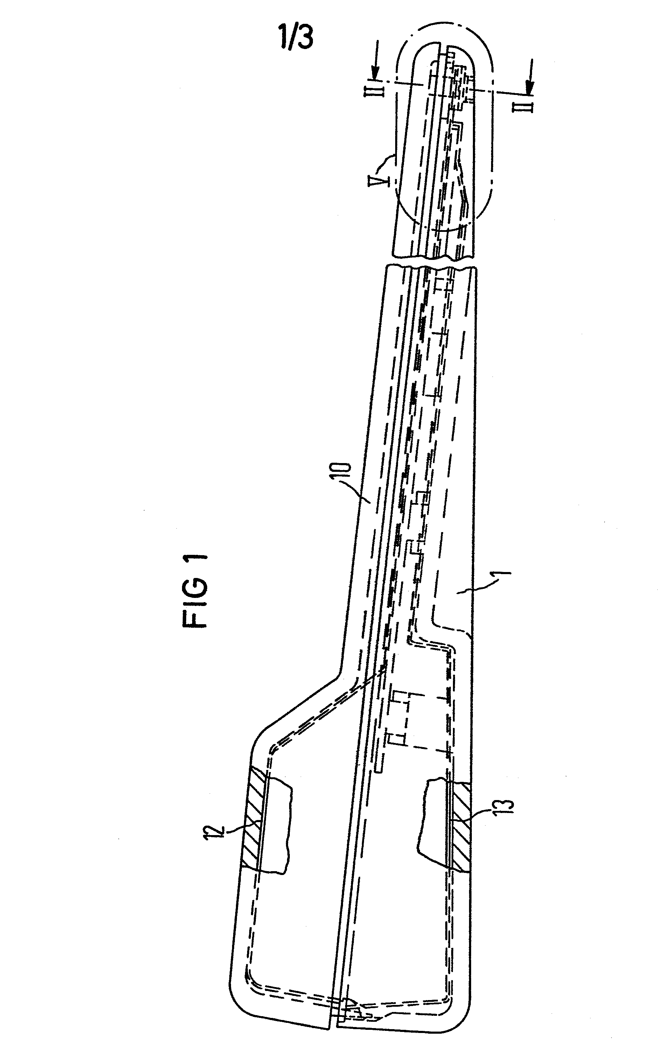

Fig. 1 zeigt die Seitenansicht eines Tastaturgehäuses, das aus dem Unterteil 1 und dem Oberteil 10 besteht, die beide aufeinander liegend miteinander verbunden sind. Im Inneren des Tastaturgehäuses befindet sich die für die elektrische Funktion notwendige Flachbaugruppe auf der Oberseite des Tastaturgehäuses das nicht dargestellte Tastenfeld. Die Verbindung von Oberteil 10 und Unterteil 1 des Tastaturgehäuses wird erfindungsgemäß durch eine Verriegel vorrichtung vorgenommen, die im vorliegenden Fall auf die vordere Längsseite des Tastaturgehäuses beschränkt ist.

Anhand eines Schnittes I/I soll die Verriegel vorrichtung nachstehend erläutert werden. Am Tastaturunterteil 1 sind Durchbrüche 2 so angeordnet, daß eine Führung 3 entsteht.

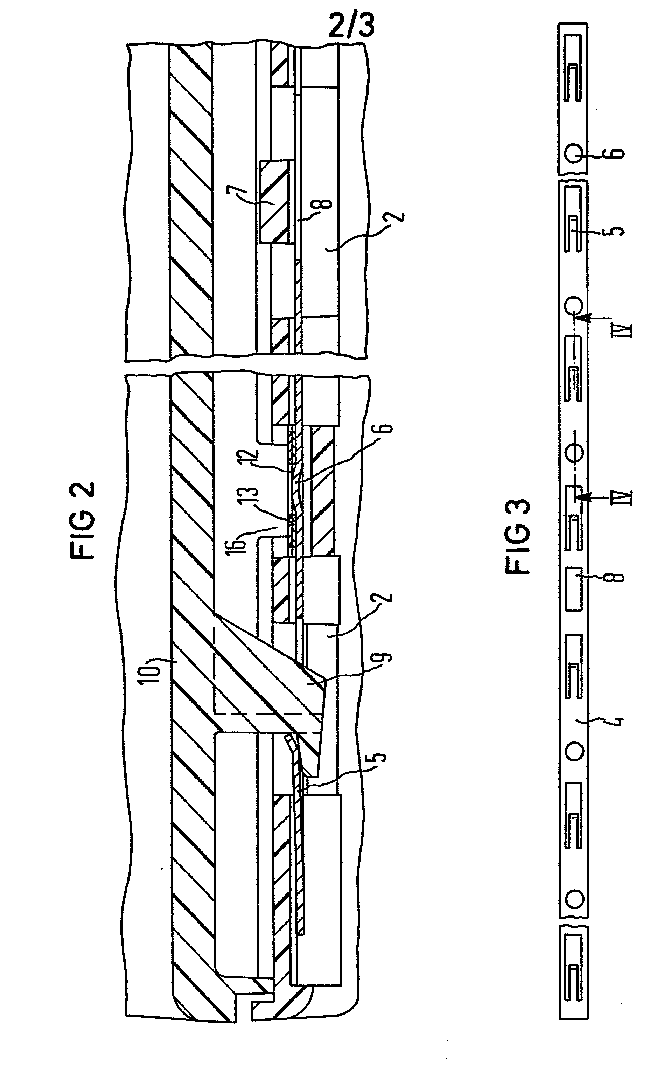

In dieser Führung 3 wird die Verschlußschiene 4 mit Kontaktzungen 5 und Kontaktbuckeln 6 eingeschoben. Diese Verschlußschiene 4 ist in Fig. 3 näher dargestellt. Die Kontaktzungen 5 sind dabei im Abstand von am Oberteil 10 des Tastaturgehäuses angeordneten Haken 9 schräg nach oben abgebogen, angeordnet. Der Schnitt II/II zeigt dabei in vergrößerter Darstellung die Verschlußschiene 4 mit den abgebogenen Kontaktzungen 5 und den Kontaktbuckeln 6. Die Verschlußschiene 4 besteht aus Bandstahl oder ähnlichem Material. In der Mitte des Tastaturunterteils 1 befindet sich ein Steg 7 und in der Verschlußschiene 4 eine Öffnung 8, die aufeinander so abgestimmt sind, daß die Verschlußschiene 4 mittels Werkzeug betätigt werden kann. Beim Öffnen oder Schließen werden die Kontaktzungen 5 und die Kontaktbuckel 6 gleichzeitig bewegt. Diese Verschlußschiene kann in Abweichung der vorliegenden Darstellung auch zwei- oder allseitig verwendet werden. Bei einem einseitigen Verschluß der Tastatur sind die restlichen drei Seiten durch Überlappung des Tastaturoberteils 10 und des Tastaturunterteils 1 und defininierten Kontaktstellen für statische Entladung sowie elektromechanische Verträglichkeit abgedichtet. Im geschlossenen Zustand der Tastatur greifen die Kontaktzungen 5, wie in Fig. 2 dargestellt, in die Haken 9 ein, die am Tastaturoberteil 10 beispielsweise angespritzt sind. Für normale Schirmausführungen bei Tastaturen werden die Ober- und Unterteile 1, 10 innenseitig metallisiert. Die Kontaktierung erfolgt dann über die Kontaktzungen 5 und die Haken 9.

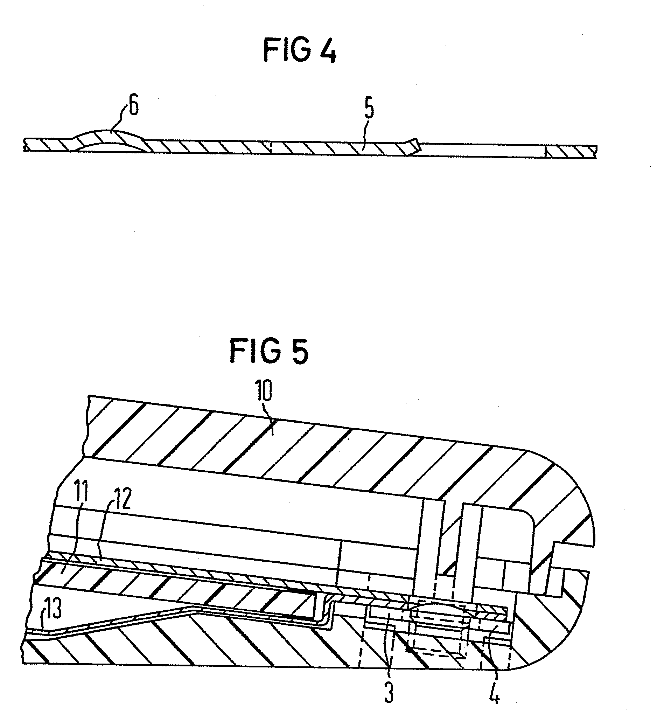

Bei Schirmung für höhere Ansprüche, wie z. B. statische Entladung wird, wie in Fig. 5 gezeigt, die Flachbaugruppe 11 in zwei Schirmbleche 12 und 13 eingebettet, so daß ein Faradayscher Käfig entsteht. Die Kontaktierung der Schirmbleche 12 und 13 untereinander und der Flachbaugruppe 11 erfolgt über die Kontaktbuckel 6 und die Gegenlage 14 am Tastaturoberteil 10.

5 Figuren
4 Patentansprüche

Patentansprüche

1. Verriegelvorrichtung für ein zweiteiliges Tastaturgehäuse aus Kunststoff mit innenseitig angeordneter
Schirmung, d a d u r c h   g e k e n n z e i c h n e t,
daß das Tastaturgehäuseunterteil mindestens an einer
Seite, vorzugsweise an der Vorderseite Durchbrüche (2) aufweist, in die am Tastaturgehäuseoberteil (10) befestigte
Haken (9) eingreifen, daß unterhalb der Durchbrüche (2)
in einem Führungskanal (3) eine Verschlußschiene (4) verschiebbar angeordnet ist, die im Abstand der Haken (9) mit nach
oben gebogenen Kontaktzungen (5) und dazwischen mit
Kontaktbuckeln (6) versehen ist, und daß sich in der Mitte
der Seiten des Tastaturunterteils vorzugsweise an der Vorderseite ein Steg (7) und in der Verschlußschiene (4)
eine Öffnung (8) befinden, die aufeinander so abgestimmt
sind, daß die Verschlußschiene (4) mittels Werkzeug verschiebbar ist.

2. Verriegelvorrichtung nach Anspruch 1, d a d u r c h
g e k e n n z e i c h n e t, daß die Verschlußschiene (4)
aus Bandstahl besteht.

3. Verriegelvorrichtung nach einem der vorhergehenden
Ansprüche, d a d u r c h   g e k e n n z e i c h n e t,
daß die Innenseiten des Tastaturober- und unterteils
(1, 10 ) metallisiert sind.

4. Verriegelvorrichtung nach Anspruch 1 oder 2,
d a d u r c h   g e k e n n z e i c h n e t, daß auf
den Innenseiten des Tastaturober- und unterteils (1, 10)
Schirmbleche (12, 13 )eingelegt sind.

0127164

1/3

FIG 1

# FIG 2

10
16 13 12
7
5 9 2 6 8
2

# FIG 3

4 8 IV IV 5 6

FIG 4

FIG 5